# EUROPEAN PATENT SPECIFICATION

(11) **EP 3 482 425 B1**
(45) Date of publication and mention of the grant of the patent: **08.09.2021**
(21) Application number: 17739532.4
(22) Date of filing: 05.07.2017
(51) Int. Cl.: H01L 41/37, H01L 41/09, H01L 41/18

(54) **SHAPE CHANGE DEVICE**
FORMWECHSELVORRICHTUNG
DISPOSITIF DE CHANGEMENT DE FORME

(30) Priority: 05.07.2016 EP 16177873
(43) Date of publication of application: 15.05.2019
(73) Proprietor: Koninklijke Philips N.V., 5656 AG Eindhoven (NL)
(72) Inventor: PELSSERS, Eduard, Gerard, Marie, 5656 AE Eindhoven (NL); KOVACEVIC MILIVOJEVIC, Milica, 5656 AE Eindhoven (NL); LAVEZZO, Valentina, 5656 AE Eindhoven (NL); VAN DEN ENDE, Daan, Anton, 5656 AE Eindhoven (NL); JOHNSON, Mark, Thomas, 5656 AE Eindhoven (NL); HAKKENS, Franciscus, Johannes, Gerardus, 5656 AE Eindhoven (NL); VAN DE MOLENGRAAF, Roland, Alexander, 5656 AE Eindhoven (NL)
(74) Representative: Marsman, Albert Willem
(86) International application number: PCT/EP2017/066767
(87) International publication number: WO 2018/007441

(56) References cited:
- WO-A2-01/06579
- US-A1- 2007 247 033
- US-A1- 2015 320 295

## Description

### FIELD OF THE INVENTION

This invention relates to a device having a member that can deform. The invention also pertains to a method for making the device. The device and method make use of electroactive polymer materials for inducing the deformation using electrical stimuli.

### BACKGROUND OF THE INVENTION

Electroactive polymers (EAPs) are an emerging class of materials within the field of electrically responsive materials. EAPs can work as sensors or actuators and can easily be manufactured into various shapes allowing easy integration into a large variety of systems.

Materials have been developed with characteristics such as actuation stress and strain which have improved significantly over the last ten years. Technology risks have been reduced to acceptable levels for product development so that EAPs are commercially and technically becoming of increasing interest. Advantages of EAPs include low power, small form factor, flexibility, noiseless operation, accuracy, the possibility of high resolution, fast response times, and cyclic actuation.

The improved performance and particular advantages of EAP material give rise to the possibility of new applications.

An EAP device can be used in any application in which a small amount of movement of a component or feature is desired, based on electric actuation. Similarly, the technology can be used for sensing small movements.

The use of EAPs enables functions which were not possible before, and offers a big advantage over common sensor / actuator solutions, due to the combination of a relatively large deformation and force in a small volume or thin form factor, compared to common actuators. EAPs also give noiseless operation, accurate electronic control, fast response, and a large range of possible actuation frequencies, such as 0 - 1MHz, most typically below 20 kHz.

Devices using electroactive polymers can be subdivided into field-driven and ionic-driven materials.

Examples of field-driven EAPs include Piezoelectric polymers, Electrostrictive polymers (such as PVDF based relaxor polymers) and Dielectric Elastomers. Other examples include Electrostrictive Graft polymers, Electrostrictive paper, Electrets, Electroviscoelastic Elastomers and Liquid Crystal Elastomers.

Examples of ionic-driven EAPs are conjugated/conducting polymers, Ionic Polymer Metal Composites (IPMC) and carbon nanotubes (CNTs). Other examples include ionic polymer gels.

Field-driven EAPs are actuated by an electric field through direct electromechanical coupling. They usually require high fields (volts per meter) but low currents. Polymer layers are usually thin to keep the driving voltage as low as possible. Ionic EAPs are activated by an electrically induced transport of ions and/or solvent. They usually require low voltages but high currents. They require a liquid/gel electrolyte medium (although some material systems can also operate using solid electrolytes).
Both classes of EAP have multiple family members, each having their own advantages and disadvantages.

A first notable subclass of field driven EAPs are Piezoelectric and Electrostrictive polymers. While the electromechanical performance of traditional piezoelectric polymers is limited, a breakthrough in improving this performance has led to PVDF relaxor polymers, which show spontaneous electric polarization (field driven alignment). These materials can be pre-strained for improved performance in the strained direction (pre-strain leads to better molecular alignment). Normally, metal electrodes are used since strains usually are in the moderate regime (1-5%). Other types of electrodes (such as conducting polymers, carbon black based oils, gels or elastomers, etc.) can also be used. The electrodes can be continuous, or segmented.

Another subclass of interest of field driven EAPs is that of Dielectric Elastomers. A thin film of this material may be sandwiched between compliant electrodes, forming a parallel plate capacitor. In the case of dielectric elastomers, the Maxwell stress induced by the applied electric field results in a stress on the film, causing it to contract in thickness and expand in area. Strain performance is typically enlarged by pre-straining the elastomer (requiring a frame to hold the pre-strain). Strains can be considerable (10-300%). This also constrains the type of electrodes that can be used: for low and moderate strains, metal electrodes and conducting polymer electrodes can be considered, for the high-strain regime, carbon black based oils, gels or elastomers are typically used. The electrodes can be continuous, or segmented.

A first notable subclass of ionic EAPs is Ionic Polymer Metal Composites (IPMCs). IPMCs consist of a solvent swollen ion-exchange polymer membrane laminated between two thin metal or carbon based electrodes and requires the use of an electrolyte. Typical electrode materials are Pt, Gd, CNTs, CPs, Pd. Typical electrolytes are Li+ and Na+ water-based solutions. When a field is applied, cations typically travel to the cathode side together with water. This leads to reorganization of hydrophilic clusters and to polymer expansion. Strain in the cathode area leads to stress in rest of the polymer matrix resulting in bending towards the anode. Reversing the applied voltage inverts bending. Well known polymer membranes are Nafion® and Flemion®.

Another notable subclass of Ionic polymers is conjugated/conducting polymers. A conjugated polymer actuator typically consists of an electrolyte sandwiched by two layers of the conjugated polymer. The electrolyte is used to change oxidation state. When a potential is applied to the polymer through the electrolyte, electrons are added to or removed from the polymer, driving oxidation and reduction. Reduction results in contraction, oxidation in expansion.

In some cases, thin film electrodes are added when the polymer itself lacks sufficient conductivity (dimension-wise). The electrolyte can be a liquid, a gel or a solid material (i.e. complex of high molecular weight polymers and metal salts). Most common conjugated polymers are polypyrolle (PPy), Polyaniline (PANi) and polythiophene (PTh).

An actuator may also be formed of carbon nanotubes (CNTs), suspended in an electrolyte. The electrolyte forms a double layer with the nanotubes, allowing injection of charges. This double-layer charge injection is considered as the primary mechanism in CNT actuators. The CNT acts as an electrode capacitor with charge injected into the CNT, which is then balanced by an electrical double-layer formed by movement of electrolytes to the CNT surface. Changing the charge on the carbon atoms results in changes of C-C bond length. As a result, expansion and contraction of single CNT can be observed.

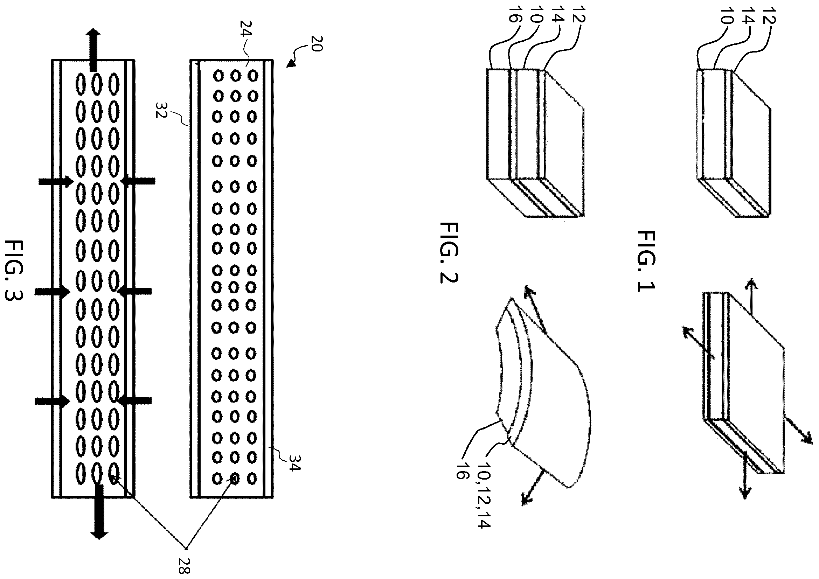

Figures 1 and 2 show two possible operating modes for an EAP device.

The device comprises an electroactive polymer layer 14 sandwiched between electrodes 10, 12 on opposite sides of the electroactive polymer layer 14.
Figure 1 shows a device which is not clamped. A voltage is used to cause the electroactive polymer layer to expand in all directions as shown.
Figure 2 shows a device which is designed so that the expansion arises only in one direction. The device is supported by a carrier layer 16. A voltage is used to cause the electroactive polymer layer to curve or bow.

Together, the electrodes, electroactive polymer layer, and carrier may be considered to constitute the overall electroactive polymer structure.

The nature of this movement for example arises from the interaction between the active layer which expands when actuated, and the passive carrier layer. To obtain the asymmetric curving around an axis as shown, molecular orientation (film stretching) may for example be applied, forcing the movement in one direction.

The expansion in one direction may result from the asymmetry in the EAP polymer, or it may result from asymmetry in the properties of the carrier layer, or a combination of both.

An electroactive polymer structure as described above may be used both for actuation and for sensing. The present invention relates in particular to actuation.

For a number of applications, local control of the shape or profile of a device contact surface is desirable. This is particularly so for devices for which contact with human tissue is a part of their operation, for instance medical or personal care devices. Here, means for controlling the shape or contour of skin-contacting surfaces of the device may be desirable, for instance to achieve optimal skin/tissue interfacing, or to perform local manipulation of tissue, such as in the case of massage, friction control or cleaning.

There are known solutions which make use of electroactive polymers in order to effect movement or deformation of a device surface.

US 6586859 B2 for instance discloses arrangements of electroactive polymer transducers attached on the inside of a flexible polymer mold and adapted to effect in-plane deformations at the surface of the mold. The arrangements are intended for use in animated devices, and in particular for animatronic face embodiments, in which a set of EAP transducers are arranged at different positions, each coinciding with a different facial feature, and adapted to effect movement of said feature at the device surface. Each EAP actuator is driven by a unique set of electrodes and is individually controlled (to enable independent control of each facial feature). Each actuator manipulates a different region of the 'face' surface.

US 2007/0247033 A1 discloses arrangements for catheter devices which comprise one or more layers of EAP material embedded within a lumen wall of the catheter. These may enable radial expansion of the lumen, or bending, flexing or steering of the catheter. Each of the EAP layers is activated separately and individually, and is driven by a separate set of stimulating electrodes. It is also disclosed that the layers may be replaced by films, fibers, bundles of fibers or particles. Further devices and methods are described in WO 01 / 06579 A2 and US 2015 / 0320295 A1.

### SUMMARY OF THE INVENTION

The hereinbefore mentioned known solutions are based on the use of individual embedded EAP actuators, being used to each actuate movement or deformation of single respective entire broad region of a surface, and typically to effect such movement or deformation in an entirely uniform manner across that region. These solutions are intrinsically limited in terms of the degree of sensitivity or precision they can offer in controlling the shape or topological profile of a device's surface. Careful control of the precise profile or shape across a relatively small surface region for instance is not achievable.

Devices are desired therefore which can enable more precise or adaptable control of the shape or profile of device surfaces.

It is an object of the invention to address the above issue.

This object is achieved with the invention as defined by the independent claims. The dependent claims provide advantageous embodiments.

According to an aspect of the invention, there is provided a device, comprising:
a compliant material member, having a volume with dispersed therein a plurality of electroactive polymer micro-particles. The particles are adapted to deform in response to application of an electrical stimulus. This can then effect a shape change of the compliant material member, and thereby effect a non-uniform deformation profile across a surface of the device. The device can there with be a shape-change device.

In particular, a controller is configured to control the compliant material member by application of an electrical stimulus to the one or more electrode arrangements to effect a shape change of the compliant material member, the shape change causing a non-uniform deformation profile across the deformable surface.

More particularly, according to embodiments, the one or more electrode are controlled to apply electrical stimuli to the plurality of micro-particles, the stimuli being configured to induce differing actuation responses in different regions of the compliant material member to thereby effect a shape change of the compliant material member configured to cause a non-uniform deformation profile across the deformable surface.

In contrast to known approaches, the invention is based on the concept of utilising large clusters or arrangements of embedded electroactive polymer (EAP) micro-particles to effect movement or deformation of the surrounding compliant material matrix within which they are contained. By using many small particles, granules or pellets of EAP material, as opposed to traditional large-scale layers or bodies of EAP, much finer control over the compliant material deformation can be achieved. The micro-particles are able to effect changes in the shape of the compliant material surface on a smaller scale, enabling finer precision in control of the ultimate adopted surface profile.

Additionally, EAP material is more expensive than typically compliant materials, and hence such arrangements can reduce costs of devices.

The electrical stimuli are configured to effect differing actuation responses in different regions. By this is meant that the actuation responses induced in every region are not identical. The 'actuation response' means, in broad terms, the mechanical response induced in each region of the compliant material member, for instance the force which the region is induced to exert, or the stress induced in the region, or the strain induced in the region or the magnitude (i.e. size) of deformation induced in the region.

In some regions, there may be no actuation response induced. This may for instance be because there are no particles located in that region, or because no stimulus is applied to that region (i.e. a stimulus of zero magnitude). Some regions may be controlled to effect similar or identical responses. Similar or identical responses may be induced in alternately spaced regions for example, with intermediary regions controlled to exhibit a different response, i.e. a larger or smaller response or no response at all.

The differing actuation responses may be realised in a range of different ways. In accordance with at least one set of embodiments, the stimuli may be configured to induce differing actuation responses in differing regions of the compliant material member based on one or more of: differing electrical stimuli applied to different regions of the compliant material member; differing densities of micro-particles in different regions of the material member; and differing shapes and/or sizes or micro-particles in different regions of the compliant material member.

By way of example, the particles may be uniformly distributed. In this case, the different actuation responses may be effected by application of electrical stimuli of differing magnitude to different regions of the particles. By 'differing magnitude' is meant, where the stimulus is an alternating stimulus (e.g. an alternating current or alternating electric field), a stimulus of a different amplitude. Where the stimulus is non-alternating, e.g. a constant DC stimulus or constant field, different magnitude means different DC current or different field strength.

There may be provided a plurality of electrode arrangements, controlled by the controller to apply said electrical stimuli of differing magnitudes to different regions of the member. In this way, differing actuation responses are effected.

By way of further example, the micro-particles may be non-uniformly distributed, with a greater density of particles in some regions of the compliant material member and a lesser density in others. In these examples, electrical stimuli of uniform magnitude may be applied to all the regions. Differing actuation responses are nonetheless induced by consequence of the differing particle densities, with regions of greater particle density exhibiting greater response and vice versa.

These means of inducing differing actuation responses will be described in greater detail in passages to follow.

The micro-particles and/or the electrode arrangements are configured to thus enable differing actuation responses to be induced in different regions of the compliant material member. The differing actuation responses thereby effect a shape change of the compliant material member configured to cause a non-uniform deformation profile to be realised across a surface of the device. A non-uniform deformation profile means a non-uniform out-of-plane deformation profile (in cases where the non-deformed surface defines a plane). A non-uniform deformation profile may imply a deformation in the shape or topology of the surface which varies in its magnitude, extent and/or direction across the surface. A non-uniform deformation profile may result for example in a surface profile which varies in its out-of-plane 'height' across the surface, for example an undulating surface profile or a surface profile comprising one or more peaks or troughs.

In operation, the micro-particles are stimulated in plural groups or sets. Each may be stimulated by a single electrode arrangement. The groups or sets may vary in size or shape at different locations across the compliant material layer. Additionally, the groups or sets may in accordance with some embodiments be varied dynamically in terms of their size, shape and/or relative position with the compliant material during operation of the device.

The provided arrangement of plural embedded EAP elements hence offers greater flexibility in terms of achievable modes and forms of deformation of the compliant material member. In embodiments, a different selection or configuration of 'regions' of the dispersed EAP particle arrangement may be electrically activated in accordance with different desired deformation patterns.

The compliant material member is comprised of a material which is flexible or passive, such that the material follows the shape change of the EAP elements embedded within it.

The 'micro-particles' are particles of EAP material having maximum outer extension of less than 100µm, and in particular embodiments, less than 10µm. In more specific examples still, the micro-particles may have maximum outer extension of between 0.1µm and 3 µm. The micro-particles may have a round cross section, for example being spherical or elliptical, or may comprise rods or fibres having any desired cross-section, for example round or diamond shaped.

For brevity, the term 'particle' may in this document be used interchangeably with the term 'micro-particle'. The two are to be interpreted identically, as referring to a 'micro-particle' as defined above.

In embodiments, the different regions may be spaced with respect to one another in directions parallel with said surface. In particular, each of said different regions may be aligned with or map onto a different respective region of the deformable surface. In this way, the actuation response induced in each different region may effect a deformation response in a different respective region of the deformable surface, these together then forming the non-uniform deformation profile.

In accordance with at least one set of embodiments, the plurality of micro-particles may comprise a plurality of subsets of micro-particles, and wherein the electrical stimuli are configured to induce differing actuation responses in different of said subsets. By this is meant that the actuation responses induced are not identical in every subset. The subsets may be the same size or may be different sizes. The subsets may be spatially separated from one another, or may be contiguously arranged. The subsets may in at least one set of examples be spaced with respect to another in directions parallel with the deformable surface.

The effect of inducing different responses in different subsets is that different actuation responses may be induced in different regions of the plurality of micro-particles. The different subsets may correspond to the different plural sets of micro-particles or may constitute or comprise only portions or sections of these plural sets

Different stimuli may be applied to different subsets of the micro-particles. There may be stimuli applied to only some subsets of particles, with no stimulus applied to other subsets. For the avoidance of doubt, it is anticipated that this feature might be combined or included in any embodiment of the present invention disclosed in this application or covered by the claims.

The plurality of electroactive polymer micro-particles may be dispersed in at least two dimensions within the volume of the compliant material member, and optionally in three dimensions. The plurality of EAP particles in this case form an arrangement which extends in at least two dimensions and possibly three dimensions. Such a configuration may maximise the flexibility of achievable deformation patterns and enhance the degree of control offered over the shape or topology of the device surface.

One or more of the electrode arrangements may be operable to apply an electrical stimulus to a plural set of EAP particles extending in two, or optionally three dimensions.

One or more of the electrode arrangements may be operable to apply an electrical stimulus to a plural set of EAP particles which extends in fewer dimensions than does the overall arrangement of micro-particles. For instance, where the plurality of EAP particles extends across three dimensions within the compliant material member, one or more of the electrode arrangements may be operable to apply an electrical stimulus to a plural set extending in just two dimensions.

According to at least one set of examples, the plurality of electroactive polymer micro-particles may be arranged having a density which is homogenous across the volume of compliant material member. As noted above, according to this arrangement, a non-uniform deformation profile or pattern across the surface of the device may be achieved through applying a non-uniform pattern of stimulation across the homogenous distribution of particles. Some regions may be stimulated by one or more electrode arrangements, while others are left idle. Alternatively, some regions may be stimulated at a greater intensity (actuating a greater magnitude of deformation in the compliant material member) than others. Alternatively still, the non-uniform surface deformation may be achieved through the use of intermittently positioned incompliant material components, adapted to affect the compliancy of particular regions of the member. These examples are described in greater detail below.

According to an alternative set of examples, the plurality of electroactive polymer micro-particles may be arranged having a density which varies across the volume of the compliant material member. The density may vary in a manner commensurate with a desired variation in deformation across the surface of the device. In this case, the non-uniform deformation pattern or profile in the surface topology or relief may be achieved by applying a simple uniform stimulation pattern across the entire arrangement of EAP particles (or a portion thereof).

The device may in certain embodiments further comprise an inflexible backing layer coupled across a major surface of the compliant material member, to effect a bending of the compliant material layer in response to deformation of the electroactive polymer micro-particles. The inflexible, or incompliant, backing layer may extend across the entire extent of one major surface of the device, thereby limiting the flexibility of the layer to expand in directions parallel with said backing layer. If the micro-particles are stimulated to deform in these directions therefore, the layer is forced to buckle or bend in a direction tangential to the backing layer surface. This would effect a change in the global shape of the volume of the compliant material member.

According to one or more sets of examples, the inflexible backing layer may comprise a plurality of isolated sections positioned along said surface, to induce uneven bending of the compliant member in response to deformation of the electroactive polymer micro-particles. In this case, certain sections of the material member would be free to expand parallel with the layer, while others would not. Expansion of the EAP particles in this case would trigger a non-uniform or uneven buckling or bending pattern across the member in direction parallel with the major surface to which the backing layer sections are coupled. This would induce shape change in the compliant material member effecting a non-uniform change in the topology of the surface of the compliant material member.

The uneven bending may comprise for instance undulant bending. It may imply a curvature over the surface having a gradient which changes over the surface.

According to one or more anticipated embodiments, the shape change device may further comprise a flexible backing layer coupled across a major surface of the compliant material member, and having an elasticity which varies across said major surface. The non-uniform flexibility of the backing layer results in a commensurate non-uniform flexibility across the compliant material member. Hence expansion of the member in directions parallel with the flexible backing layer (caused by EAP particle deformations) will result in a non-uniform bending pattern across the layer, with greater bending occurring at regions of locally lower stiffness and more bending across regions having greater stiffness.

The relatively lower-stiffness sections of the passive backing layer may have a stiffness that is sufficiently low that no bending of the layer occurs across regions covered by those sections. This may result in an undulant bending of the layer for instance.

This embodiment may be combined with a homogenous distribution of particles to enable non-homogenous deformation at the device surface.

Alternatively, the embodiment may be combined with an inhomogeneous distribution of micro-particles, e.g. micro-particles provided only across areas of the layer falling beneath stiffer sections. This would enable local surface protrusions or bumps to be effected across the thicker sections.

According to certain examples, the device may comprise a plurality of electrode arrangements, each independently operable to apply an electrical stimulus to a spatially distinct subset of the electroactive polymer micro-particles. There may be provided an array of electrode arrangements for instance. These examples enable a variable activation pattern across different regions of the EAP particle arrangement, and hence variable deformation of the surrounding compliant material member. By selectively activating different configurations of the plurality of electrode arrangements, different deformation patterns at the device surface can be effected.

In accordance with one or more embodiments, the plurality of electroactive micro-particles may comprise a first subset of micro-particles having a first shape, size and/or orientation, and at least a second subset of micro-particles having a second shape, size and/or orientation. The different subsets may correspond to spatially distinct sub-regions of the arrangement of micro-particles. Varying the shape, size or orientation of particles across different spatial regions may introduce a further local variability in the deformation pattern induced across the layer in response to activation of the EAP particles. This hence may enable even greater control over the achievable deformation patterns across the surface.

In one or more embodiments, the compliant material member may have a thickness which varies across at least one dimension of the member. Such a varying thickness may introduce further variability in the deformation response of the material to stimulation of the EAP particles. It may for instance make the thicker sections stiffer and the thinner sections less stiff. This embodiment may be combined for instance with a homogenous distribution of particles, stimulated with a homogenous stimulation pattern, but nonetheless providing a non-uniform deformation response across the layer surface.

In accordance with any of the embodiments outlined above, a maximum size dimension (extension) of each of the plurality of electroactive polymer micro-particles may be between 0.1 and 3 micrometres.

According to any embodiment, the plurality of electroactive polymer particles and the compliant material member form a composite structure having a total volume, and wherein the plurality of electroactive polymer particles constitute a fraction of this total volume of between 1% and 70%, and optionally wherein they constitute a fraction of the total volume of between 20% and 50%.

According to one set of embodiments, the plurality of EAP micro-particles consists of a single row of spatially separated micro-particles, each extending between a first major surface of the compliant material member, and a second, opposing major surface of the compliant material member.

In accordance with a further aspect of the invention, there is provided a method of producing a device according to the invention, the method comprising:
forming the compliant material member by means of a compound extrusion process.

By controlling the rate of dosing, one can change the density of the EAP micro-particles embedded within the compliant material. This can be done along a layer of the compliant material member.

In examples, providing the electrode arrangements may comprise printing one or more electrodes on each of a first and second major surface of the flexible material member.

In accordance with one or more embodiments, the method may further comprise controlling the rate at which the flexible material is dosed with electroactive polymer particles so as to vary over time.

By varying the rate of dosing with time, one can control the density pattern of the EAP particles within the flexible material member. An inhomogeneous distribution of particles having a particular pattern of inhomogeneity can be achieved.

### BRIEF DESCRIPTION OF THE DRAWINGS

Examples of the invention will now be described in detail with reference to the accompanying drawings, in which:
Figure 1 shows a known EAP device which is not clamped;
Figure 2 shows a known EAP device which is constrained by a backing layer;
Figure 3 shows an example device;

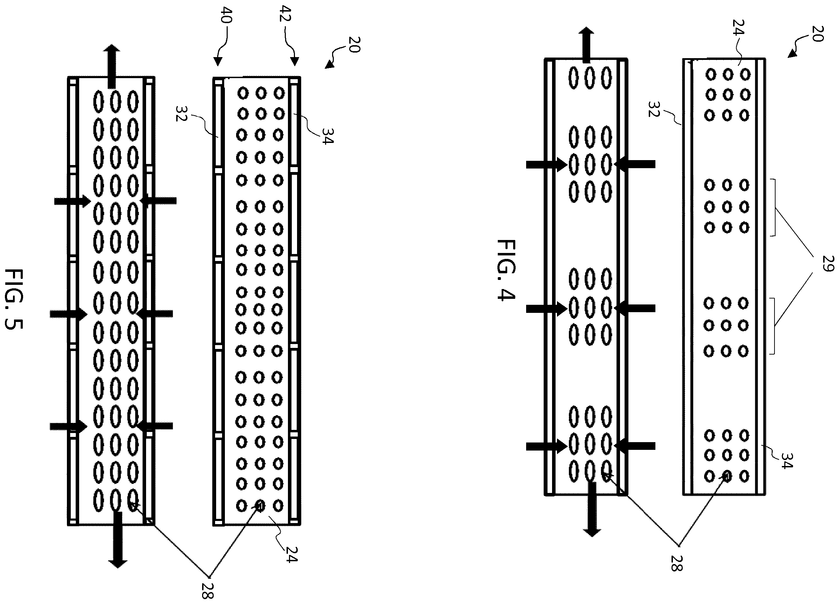

Figures 4 to 10 show example devices according to the invention.

### DETAILED DESCRIPTION OF THE EMBODIMENTS

The invention provides a device utilising a plurality of particles of electroactive polymer material embedded within a compliant material matrix and adapted to deform in response to application of an electrical stimulus. The device can be a shape-change device. A resultant shape-change of the compliant matrix enables realisation of a particular deformation profile across a surface of the compliant material. Particles are stimulated in plural groups by one or more arrangements of electrodes. Shapes, sizes, dimensionalities and locations of stimulated EAP particle regions may be selectively chosen to initiate a particular response in the material, and produce a particular desired deformation profile across the material surface.

Figure 3 shows a first example device. The figure shows the device before (upper drawing) and after (lower drawing) electrical stimulation. The device comprises a compliant material member 20 hosting a plurality of electroactive polymer (EAP) particles 28 embedded and dispersed homogenously within a compliant material matrix 24. A pair of electrodes 32, 34 is affixed across a top and bottom major surface respectively of the compliant material member 20. Also provided is a controller (not shown) adapted to controllably apply a potential difference to the electrodes 32, 34, to thereby induce an electric field across the member 20.

Upon application of an electric field between electrodes 32, 34, the plurality of EAP particles collectively undergo a simultaneous expansion along a width-wise direction (as seen from the perspective of Figure 3). This collective deformation induces a corresponding deformation response in the surrounding compliant material matrix 24, wherein the compliant material member undergoes a lateral expansion or stretching in one or more directions parallel to the top and bottom major surfaces of the member.

As the compliant member 20 expands, so the top and bottom major surfaces undergo an in-plane deformation parallel with this expansion. By controlling the magnitude of potential difference applied to the electrodes 32, 34, different degrees of in-plane deformation can be achieved. Furthermore, as explained further below, the electrode arrangement can be controlled in at least one mode to provide a controlled non-uniform deformation profile.

According to the particular example shown in Figure 3, the deformation profile induced across major surfaces (18, 19) on opposite sides of the compliant material member 20 consists of an in-plane deformation. However, it will be clear to the skilled reader that by application of suitable clamping means, this might be transformed into a corresponding out-of-plane deformation profile, e.g. in a way as described with reference to Figure 2. Or, for example, by clamping side surfaces of the member, such that in-plane expansion of the member (parallel with top and bottom major surfaces of the member) is restricted, the member may be induced to deform out-of plane.

Although in the arrangement shown in Figure 3, the particles are represented as spherical particles, according to alternative examples the particles may have any of a wide variety of shapes or forms. The particles may be oval-shaped, cylindrical, or comprise rods, fibres or wafers for instance.

Furthermore, although the particles are shown arranged according to an ordered array formation, this is by no means necessary. In alternative examples, the particles may be homogenously distributed in a random, non-ordered configuration, without any necessary deterioration of the performance of the device.

For the example of Figure 3, it is assumed that the EAP particles comprise a field-driven EAP, such that they may be stimulated by application of an electric field between electrode pair 32, 34. However, in alternative embodiments, ionic (or current) driven EAP materials may be used for the EAP particles. In such cases, the compliant material may need to comprise a suitable ion exchange membrane or (poly) electrolyte matrix. Additionally, for an ionic EAP embodiment, the electrodes 32, 34 may optionally be arranged or configured differently, for example being mounted to opposing (left and right from the perspective shown in Figure 3) ends of the compliant material member.

The configuration and design of the compliant material member and the arrangement of the embedded particles may, according to further examples, be adapted so as to achieve different particular deformation effects in response to the application of the electrical stimulus.

Figure 4 shows a second example device in accordance with embodiments of the invention. According to this arrangement, the electroactive polymer particles 28 are distributed inhomogeneously across the compliant material matrix 24. In particular, the EAP particles 28 are arranged in spatially isolated sub-groups 29 (two of which are indicated by reference 29 by way of illustration). Upon application of a potential difference to electrodes 32, 34, the particles 28 across all of the subgroups are simultaneously stimulated.

The resultant deformation of the particles leads to an inhomogeneous deformation response across the compliant material matrix 24. Regions of the matrix immediately surrounding each of the subgroups 29 undergo a strong deformation response, in directions parallel to the two major surfaces of the compliant material member 20. Regions of the matrix falling in between the subgroups, while undergoing some deformation, experience a much weaker overall deformation response.

As a result of the inhomogeneous deformation of the compliant matrix 24, a non-uniform in-plane deformation of the compliant member major surfaces is elicited, having a magnitude or amplitude which varies across the surface. This varying deformation corresponds equivalently to a varying induced strain across different regions of the member and its major surfaces. A greater magnitude of strain will be induced across regions directly above and below each of the EAP particle subgroups 29, and a lesser strain will be induced across regions falling in-between each of the subgroups. Such a non-uniform in-plane deformation, or non-uniform induced strain, could have useful applications in the control of surface friction for example.

Figure 5 shows a third example device in accordance with embodiments of the invention. The device comprises a compliant material member 20 having a plurality of electroactive polymer particles 28 dispersed homogenously throughout a compliant material matrix 24. Affixed across a bottom and top major surface respectively of the member is a first 40 and second 42 spatially distributed array of electrodes. Electrodes of each array are co-operatively aligned to form a plurality of electrode arrangements, each comprising a respective pair of opposing top 34 and bottom 32 electrodes.

The device 20 further comprises a controller (not shown) adapted to control application of voltages to one or more of the electrode pairs in order to stimulate a deformation response in the member. The electrode pairs according to the present example are electrically coupled (wired or wirelessly) with the controller in such a way as to be individually addressable and individually controllable. Thus different combinations of electrode pairs may be stimulated in accordance with different desired deformation schemes.

Where homogenous deformation of the major surfaces of the member is desired for example, all of the electrode pairs may be activated, and consequently the entire arrangement of EAP particles 28 stimulated to deform (as shown by way of example in Figure 5). However, according to alternative schemes, only alternate pairs for example may be activated, in order thereby to achieve an inhomogeneous deformation response across the member surface similar to that shown in Figure 4. Further, more complex schemes of activation may also be applied, in order to induce any particular desired shape or pattern of deformation.

Considering the full two-dimensional surface of the member (extending into the page for the figures shown), a selection of electrode arrangements (electrode pairs) may be chosen corresponding to a particular shape or form. A deformation profile may then be achieved across the major surface(s) of the member commensurate with this shape or form. For example, a roughly circular pattern of electrode pairs might be selected, to induce a circular in-plane deformation. This is presented by way of example only, and alternative regular or irregular shapes or patterns may alternatively be selected.

Furthermore, although the example of Figure 5 shows respective regular arrays 40, 42 of electrodes, the concept is not limited to such an arrangement. A plural set of electrodes may be applied across each of the top and bottom major surfaces (to form a corresponding plural set of electrode pairs) in accordance with any desired regular or irregular pattern, scheme or spatial configuration. The electrodes may be sparsely distributed across the surfaces or may be arranged contiguously with one another.

Additionally, in further examples, the electrodes of each of the sets or arrays 40, 42, may be provided having much smaller dimensions than those indicated in Figure 5, to enable an even greater degree of control over achievable deformation patterns and responses. In the extreme case, each electrode may be provided having extensions with cover only the width (or diameter) of a single particle. Hence, where the particles are arranged according to an ordered array (as in the example of Figure 5), each electrode pair (electrode arrangement) would be operable to stimulate just a single 'vertical' row of particles 28.

Furthermore, although in the example shown in Figure 5, the electrode arrays 40, 42 are provided applied across major surfaces of the compliant material member 20, according to further examples, there may additionally or alternatively be provided electrodes embedded within the compliant material matrix 24 itself. This may provide an even greater degree of control over the deformation response of the compliant material member, by enabling independent stimulation of a larger number of smaller subgroups of particles.

By way of example, an additional two arrays might be provided adjacent to one another and extending laterally through the centre (or a central plane) of the compliant member, each arranged and aligned to form respective electrode pairs with the electrodes of each of the top 42 and bottom 40 electrode arrays. This is presented by way of illustration only, and any particular arrangement of embedded electrodes may also be used.

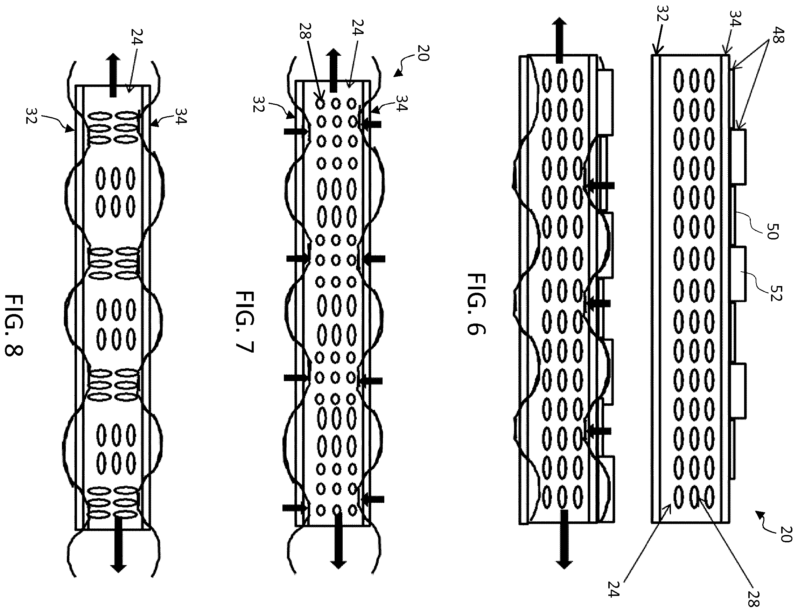

Figure 6 shows a fourth example device in accordance with embodiments of the invention. The device comprises a compliant material member 20 hosting a plurality of embedded EAP particles 28, dispersed homogenously across a compliant material matrix 24. Across a top and bottom major surface respectively of the compliant material member 20 are affixed a pair of electrodes 32, 34. Further affixed, over the top of the upper electrode 34, is a rigid (non-compliant) backing layer 48 which is formed of alternating regions of thinner 50 and thicker 52 material. The thinner material provides a more compliant (more elastic) region of the backing layer, while the thicker material provides a less compliant (less elastic) region of the backing layer.

The device further comprises a controller (not shown) adapted to control application of a potential difference to the electrode pair 32, 34 to thereby induce an electric field across the member 20. As shown in Figure 6, upon application of an electric field by the controller, the plurality of particles are stimulated to deform by expanding laterally. This induces a corresponding deformation response in the surrounding EAP matrix, wherein a lateral stress is induced across the layer in directions parallel with the major surfaces of the member.

The backing layer 48 affixed across the top surface restricts the achievable lateral deformation of the member. Across the thicker regions 52 of the layer, where compliancy is low, achievable lateral strain is highly restricted. Across the thinner regions 50 of the backing layer, the achievable lateral strain is less restricted. As a result, the stress built up in the member as a result of the deformation, forces it to deform in out-of plane directions, and thereby adopt an undulant, bent configuration, as illustrated in Figure 6.

By varying the respective widths and separation distances of the thicker 52 and thinner 50 regions of the incompliant backing layer, any desired pattern or profile of out-of-plane deformation may be achieved. As will be clear to the skilled reader, any particular surface topology may be induced to arise, simply by selectively designing the configuration of thicker and thinner regions of material to have suitable surface areas, shapes, and sizes.

According to further examples, this embodiment could be combined with an inhomogeneous distribution of particles 28 to achieve further variation and freedom in achievable deformation patterns. Additionally or alternatively, the embodiment may be combined with use of a plural configuration of electrode pairs (similar to the arrangement of Figure 5 for instance).

The same broad possibilities for achieving different out-of-plane surface deformation patterns are also achievable in further embodiments by alternate design means. Figures 7 and 8 show fifth and sixth example devices respectively, each in accordance with embodiments of the invention. According to these examples, the electroactive polymer particles 28 comprise particles of different shapes distributed across the compliant material matrix 24. The arrangement of particles in Figure 7 is formed of alternating sub-sets of spherical and ellipsoidal particles. The alternating pattern is consistent across the material member.

The arrangement of particles in Figure 8 is formed of alternating sub-sets of vertically and horizontally aligned ellipsoidal particles. The alternating pattern here too is consistent across the compliant material member, but with each sub-set separated from neighbouring sub-sets by a small gap in which no particles are contained. This ensures that each sub-set covers a roughly equal length section of the compliant material member.

The compliant material member 20 in each case is provided with a single continuous pair of electrodes 32, 34 applied across bottom and top major surfaces respectively of the member. The device further comprises a controller (not shown) adapted to controllably apply potential differences to the electrodes 32, 34 in order thereby to induce an electric field across the member.

For the embodiment of Figure 7, upon application of an electric field, the spherical particles undergo a deformation similar to that illustrated in previous example embodiments, with each particle 28 expanding laterally in directions parallel with the major surfaces of the member 20. The elliptical particles, by contrast, are adapted to respond to the stimulation by expanding or stretching in a 'vertical' direction (from the perspective presented in Figure 7), substantially orthogonally to the planes defined by the major surfaces of the member.

As a consequence, a different mode of deformation response is induced across different regions of the compliant material matrix 24, resulting in a non-uniform deformation profile across the major surfaces. For instance, across the regions containing the elliptical particles, a substantially 'vertical' stretching of the member is induced, whereas across the regions containing spherical particles, a substantially lateral stretching is applied. The result is a non-uniform deformation profile across the major surfaces comprising both out-of-plane elements and in-plane elements. Locally different deformation responses lead to locally different shapes or patterns of bending or deformation.

A schematic depiction of the induced deformation profile is sketched in Figure 7 for illustrative purposes. Of course it will be apparent to the skilled person that in practice, the particular profile or shape of deformation induced across the surface may differ from that shown, and will depend upon the particular configuration of particles 28 and the particular deformation properties of the EAP material used.

Similarly, the embodiment of Figure 8, each sub-set of ellipsoidal particles is adapted to respond to electrical stimulation by deforming in a direction parallel with the semi-minor axis of the particle elliptical cross-section as presented in Figure 8. Hence the 'vertically' aligned ellipsoidal particles deform in a lateral direction (parallel with the major surfaces of the compliant material member) and the 'horizontally' aligned ellipsoidal particles deform in a 'vertical' direction (perpendicular to the major surfaces of the compliant material member).

This alternating pattern of 'vertical' and 'horizontal' deformation may induce a similar deformation pattern to that induced in the example of Figure 7, for example an undulating or other alternating curved pattern. A schematic depiction of the induced deformation profile is sketched in Figure 8 for illustrative purposes. Of course, as for the example of Figure 7, it will be apparent to the skilled person that in practice, the particular profile or shape of deformation induced across the surface may differ from that shown, and will depend upon the particular configuration of particles 28 and the particular deformation properties of the EAP material used.

Although in the examples shown in Figures 7 and 8, spherical and elliptical particles are shown by way of example, in further variations, particles of different shapes may additionally or alternatively be used. These may include (again, by way of non-limiting example only) rod-shaped particles or particles in the form of fibres or wafers.

According to further examples, the EAP particle 28 arrangement may include a greater variety of different particle shapes, for example three or four different shapes of particle. These may be arranged according to a regular repeating pattern of subgroups, or may be arranged in subgroups which are ordered in a different manner, for example a configuration which is less regular.

The differently shaped particles may not be arranged in shape-specific subgroups, but may be mixed together.

This embodiment may further be advantageously combined with the use of a plural arrangement of electrode pairs, to thereby enable independent stimulation of different spatial regions of the EAP particles. The electrode pairs may be arranged to coincide with the different subsets of alternately shaped particles. Alternatively, they may be arranged according to a different configuration. A plurality of electrodes may cover each subset (in the case that sufficiently small electrodes are used for instance).

This or any other embodiment described in connection with the invention may also be advantageously combined with use of a compliant material member which varies in thickness laterally across its extent. This may be a continuously decreasing or increasing change in thickness, or may be a thickness which fluctuates across the member.

Non-uniform thickness may introduce further inhomogeneity to the deformation response of the compliant matrix and thereby to the resultant deformation profiles established across the major surfaces.

Additionally, in this or any other embodiment, there may be provided a compliant material member 20 formed of a compliant material which varies in density or elasticity across the member. This may, again, be a continuous pattern of variation or a fluctuating one. This may again add a further source of inhomogeneity or variability to the deformation response of the member.

Furthermore, the use of particles of different shapes may in particular examples, be advantageously combined with any embodiment of the present invention to achieve further adaptation of the obtained surface deformation profiles.

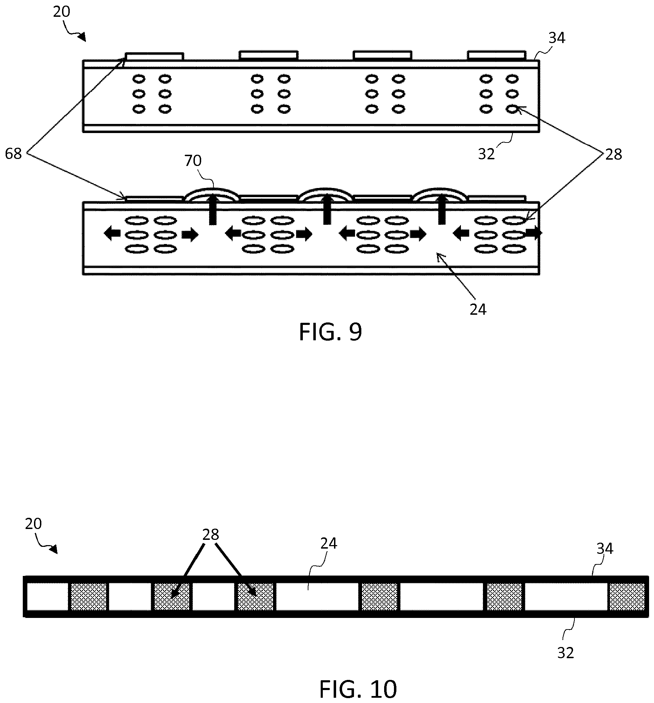

In Figure 9 is shown a seventh example device in accordance with embodiments of the invention. The device comprises a compliant material member 20, hosting a plurality of EAP particles 28 embedded within a compliant material matrix 24. The particles are arranged in a series of spatially separated subgroups, these being distributed laterally across the member. Electrodes 32, 34 are applied across a top and bottom major surface of the member for stimulating the particles.

Also provided across the top surface is a backing layer 68 formed of a flexible material which varies in thickness across the width of the member. The layer comprises thicker sections, which each extend over one of the spatially separated sets of EAP particles, and thinner sections which extend across each of the regions falling in between. The thicker sections are naturally less compliant (less flexible), while the thinner sections provide greater flexibility.

The device further comprises a controller adapted to controllably apply a potential difference across electrodes 32, 34, to establish an electric field across the member.

On application of an electric field, each of the sets of particles expands laterally (in directions parallel with the major surfaces of the compliant member 20). This results in an inward "squeezing" effect applied to each of the empty regions falling between subsets. Since the induced stress cannot be released in a lateral direction, the compliant material is induced to deform in a 'vertical direction'.

The flexible backing layer across the top of the member restricts out-of plane deformation of the surface across regions coinciding with its thicker sections. Hence out-of-plane deformation is only possible at the regions falling in between the thicker sections. The result is a plurality of out-of-plane 'bumps' 70 across the surface, coinciding with each of the regions of the compliant material member containing no EAP particles.

In alternative examples, the flexible backing layer 68 may be provided having a different design or configuration, for example comprising differently shaped, sized or positioned thicker and thinner sections. This may enable any particular desired pattern of bumps or protrusions to be formed in response to electrical stimulation.

Figure 10 shows an eighth example device in accordance with embodiments of the invention. According to this embodiment the device is formed of a single layer member 20, which comprises alternating EAP 28 and compliant material 24 sections. Each of the sections extends the entire height of the layer member 20. Extending across the top and bottom surfaces of the layer member are respective electrodes 32, 34.

The device also comprises a controller (not shown) adapted to apply a potential difference across the two electrodes 32, 34 in order to establish an electric field across the layer member 20.

Upon application of the electric field, the EAP sections 28 deform laterally (parallel with the top and bottom surfaces of the layer) and produce a concurrent deformation response across the top and bottom major surfaces of the member. In the examples shown, the EAP elements 28 are distributed inhomogeneously across the extent of the member. As a result, upon stimulation of the EAP elements, a non-uniform in-plane deformation profile is established across the surfaces, having greater magnitude or amplitude across regions coincident with the wider sections of EAP and lesser amplitude across regions coincident with shorter sections.

One advantage of this embodiment is its simple manufacture. It can be formed by printing alternate sections of EAP material 28 and compliant matrix material 24 onto the lower electrode 32, and finally finishing the layer by printing the second electrode 34 over the top.

Although in each of the example embodiments described above, substantially rectangular electrodes have been shown, according to alternative examples, electrodes of different shapes may instead be used. These might include, by way of non-limiting example only, circular, elliptical, triangular or hexagonal, or any other regular or irregular shape. Where a plurality of electrode arrangements is provided to stimulate different subsets of the EAP particles, the selected shape of electrode may enable stimulation of a correspondingly shaped sub-group of particles. This may then result in a deformation profile which follows, incorporates or is congruent with said shape. For example, a circular electrode may be used to stimulate a circular region of EAP particles and thereby induce a deformation (in-plane or out of plane) across the corresponding region of the member surface which follows that shape.

According to any of the above-described embodiments, where particles are represented as spherical particles, it is anticipated that in alternative examples the particles may have any of a wide variety of shapes or forms. The particles may be oval-shaped, cylindrical, or comprise rods, fibres or wafers for instance. The rods may have any cross-sections, including for example round, elliptical, or diamond-shaped.

Furthermore, where particles are shown arranged according to an ordered array formation, this is not intended to limit the scope of the invention. In alternative examples, the particles may be homogenously or inhomogeneously distributed in a random, non-ordered configuration, and without any necessary deterioration of the performance of the device.

Furthermore, it has been assumed in each of the example embodiments above that the EAP particles comprise field-driven EAP material, such that they may be stimulated by application of an electric field between electrode pair 32, 34. However, in alternative embodiments, ionic (or current) driven, EAP materials may be used for the EAP particles. In these cases, the compliant material may need to comprise a suitable dielectric or other current-carrying material.

According to any of the above examples, the provided controller may be adapted to apply voltages to the electrodes suitable to establish an electric field of strength in the range 10V/µm to 50V/µm to 100 V/µm. These numbers provide one example of an advantageous set of ranges which may be used, but does not imply that fields of a magnitude falling outside of this range may not also be suitable.

To establish a uniform electric field across the member, it may be necessary to adapt the voltage applied to different electrode arrangements in dependence upon the thickness, density or composition of the material falling between those electrodes (where more than one electrode arrangement is provided). Regions having a higher concentration of EAP particles for instance may require a higher applied voltage to establish the same strength of electric field than regions having a lower density of EAP particles.

Materials suitable for the EAP component are known. Electro-active polymers include, but are not limited to, the sub-classes: piezoelectric polymers, electromechanical polymers, relaxor ferroelectric polymers, electrostrictive polymers, dielectric elastomers, liquid crystal elastomers, conjugated polymers, Ionic Polymer Metal Composites, ionic gels and polymer gels.

The sub-class electrostrictive polymers includes, but is not limited to:
Polyvinylidene fluoride (PVDF), Polyvinylidene fluoride - trifluoroethylene (PVDF-TrFE), Polyvinylidene fluoride - trifluoroethylene - chlorofluoroethylene (PVDF-TrFE-CFE), Polyvinylidene fluoride - trifluoroethylene - chlorotrifluoroethylene) (PVDF-TrFE-CTFE), Polyvinylidene fluoride- hexafluoropropylene (PVDF - HFP), polyurethanes or blends thereof.

The sub-class dielectric elastomers includes, but is not limited to:
acrylates, polyurethanes, silicones.

The sub-class conjugated polymers includes, but is not limited to:
polypyrrole, poly-3,4-ethylenedioxythiophene, poly(p-phenylene sulfide), polyanilines.

Ionic devices may be based on ionic polymer - metal composites (IPMCs) or conjugated polymers. An ionic polymer - metal composite (IPMC) is a synthetic composite nanomaterial that displays artificial muscle behavior under an applied voltage or electric field.

In more detail, IPMCs are composed of an ionic polymer like Nafion or Flemion whose surfaces are chemically plated or physically coated with conductors such as platinum or gold, or carbon-based electrodes. Under an applied voltage, ion migration and redistribution due to the imposed voltage across a strip of IPMCs result in a bending deformation. The polymer is a solvent swollen ion-exchange polymer membrane. The field causes cations travel to cathode side together with water. This leads to reorganization of hydrophilic clusters and to polymer expansion. Strain in the cathode area leads to stress in rest of the polymer matrix resulting in bending towards the anode. Reversing the applied voltage inverts the bending.

If the plated electrodes are arranged in a non-symmetric configuration, the imposed voltage can induce all kinds of deformations such as twisting, rolling, torsioning, turning, and non-symmetric bending deformation.

In all of these examples, additional passive layers may be provided for influencing the electrical and/or mechanical behavior of the EAP layer in response to an applied electric field.

The EAP component of each unit may be sandwiched between electrodes. The electrodes may be stretchable so that they follow the deformation of the EAP material. Materials suitable for the electrodes are also known, and may for example be selected from the group consisting of thin metal films, such as gold, copper, or aluminum or organic conductors such as carbon black, carbon nanotubes, graphene, poly-aniline (PANI), poly(3,4-ethylenedioxythiophene) (PEDOT), e.g. poly(3,4-ethylenedioxythiophene) poly(styrenesulfonate) (PEDOT:PSS). Metalized polyester films may also be used, such as metalized polyethylene terephthalate (PET), for example using an aluminum coating.

EAPs provide unique benefits for actuation functionality mainly because of the small form factor, the flexibility and the high energy density. Hence EAPs and photoresponsive polymers can be easily integrated in soft, 3D-shaped and / or miniature products and interfaces. Examples of such applications are:
Skin cosmetic treatments such as skin actuation devices in the form of a responsive polymer based skin patches which apply a constant or cyclic stretch to the skin in order to tension the skin or to reduce wrinkles;
Respiratory devices with a patient interface mask which has a responsive polymer based active cushion or seal, to provide an alternating normal pressure to the skin which reduces or prevents facial red marks;
Electric shavers with an adaptive shaving head. The height of the skin contacting surfaces can be adjusted using responsive polymer actuators in order to influence the balance between closeness and irritation;
Oral cleaning devices such as an air floss with a dynamic nozzle actuator to improve the reach of the spray, especially in the spaces between the teeth. Alternatively, toothbrushes may be provided with activated tufts;
Consumer electronics devices or touch panels which provide local haptic feedback via an array of responsive polymer transducers which is integrated in or near the user interface;
Catheters with a steerable tip to enable easy navigation in tortuous blood vessels.

Another category of relevant application which benefits from such actuators relates to the modification of light. Optical elements such as lenses, reflective surfaces, gratings etc. can be made adaptive by shape or position adaptation using these actuators. Here one benefit of EAPs for example is lower power consumption.

Further possible fields for application of the shape-change device include ultrasound devices, tonometry, oral healthcare, and microfluidics.

Any of the above described example shape-change devices may be produced by means of a compound extrusion process, wherein the raw compliant material is fed into a suitably shaped extruder, and, either consistently or periodically, dosed with a supply of EAP material. Where a homogenous distribution of embedded EAP particles is required, the EAP material may be dosed continuously. Where spatially separated subgroups are required, the EAP material may be added periodically. Where a non-uniform density of EAP material is required, the rate at which the EAP material is added may be varied over time.

In order to achieve the desired deformation properties, the compliant material member may be formed of a material or composite having a modulus of elasticity (Young's modulus) approximately equal to (or in the same order as) the equivalent modulus of elasticity of the Electroactive Polymer particles.

Where, for example, the EAP particles are formed of an EAP material having an elastic modulus of between 0.1-10 MPa, then suitable materials for the compliant material member may include (by way of non-limiting example only) rubbers such as e.g. silicone rubber or other rubbers such as e.g. Polyacrylate Rubber; Ethylene-acrylate Rubber; Isobutylene Isoprene Butyl. Many other rubbers are known per se and those skilled in the art will know to find them in rubber or polymer handbooks. The compliant materials does not need to be a rubber material. Any other material that allows deformation due to the electrical stimulus is compliant within the definition of the invention. Where the EAP particles are formed instead of a PVDF based electroactive material (see above for more details), having a modulus of elasticity of between 500-1000 MPa, then suitable materials for the compliant material member may include Polyethylene (having Young's modulus 700MPa) or PTFE (having Young's modulus 300 MPa). Again, these are listed by way of non-limiting example only, and other suitable materials will be apparent to the skilled person.

After forming the compliant material member having embedded EAP particles according to a suitable extrusion process, the one or more electrode arrangements may be provided to each of the top and bottom major surfaces of the member. This may be achieved for example through printing. However, any other suitable means may also be used.

Other variations to the disclosed embodiments can be understood and effected by those skilled in the art in practicing the invention as defined by the claims.

## Claims

1. A device having a deformable surface, the device comprising:
- a compliant material member (20), having a volume;
- a plurality of electroactive polymer micro-particles (28) having a maximum outer extension of less than 100 µm, and being dispersed within the volume, the electroactive polymer micro-particles being adapted to deform in response to the application of an electrical stimulus;
- one or more electrode arrangements (32, 34), each operable to apply an electrical stimulus to a plural set of the electroactive polymer micro-particles (28); and
- a controller configured to control the one or more electrode arrangements to apply electrical stimuli to the plurality of micro-particles, the stimuli being configured to induce differing actuation responses in different regions of the compliant material member to thereby effect a shape change of the compliant material member configured to cause a non-uniform deformation profile across the deformable surface, **characterised in that** the stimuli are configured to induce the differing actuation responses in differing regions of the compliant material member based on one or more of:
i. differing electrical stimuli applied to different subsets of micro-particles (28) within the compliant material member (20) by means of spatially distributed arrays (40, 42) of individually addressable and individually controllable electrodes;
ii. differing densities of micro-particles (28) in different regions of the compliant material member (20); and
iii. ordered subgroups of micro-particles (28) of differing shapes and/or sizes within the compliant material member (20).

2. A device as claimed in claim 1, wherein the plurality of electroactive polymer micro-particles comprises a plurality of subsets of micro-particles, and wherein the electrical stimuli are configured to induce differing actuation responses in different of said subsets.

3. A device as claimed in any preceding claim, wherein the plurality of electroactive polymer micro-particles are dispersed in at least two dimensions within the volume of the compliant material member.

4. A shape-change device as claimed in any preceding claim, wherein
the plurality of electroactive polymer micro-particles have a density within the compliant material member which is constant or homogenous throughout the volume of compliant material member; or
the plurality of electroactive polymer micro-particles have a density which varies throughout the volume of the compliant material member.

5. A device as claimed in any preceding claim, wherein the compliant material member comprises a major surface, and the device further comprises an inflexible backing layer coupled to the major surface, to effect a bending of the compliant material member in response to an electrical stimulus, and optionally wherein
said inflexible backing layer comprises a plurality of isolated sections positioned along said major surface, to induce uneven bending of the compliant material member in response to the electrical stimulus.

6. A device as claimed in any preceding claim, wherein the compliant material member comprises a major surface, the device further comprising a flexible backing layer coupled to the major surface and having an elasticity which varies across the major surface.

7. A device as claimed in any preceding claim, comprising a plurality of electrode arrangements, each of which is independently operable to apply an electrical stimulus to a spatially distinct subset of the electroactive polymer micro-particles.

8. A device as claimed in any preceding claim, wherein the plurality of electroactive micro-particles comprises a first subset of micro-particles having a first shape, size and/or orientation in the volume, and at least a second subset of micro-particles having a second shape, size and/or orientation in the volume, which is different from the corresponding first shape, size and/or orientation.

9. A device as claimed in any preceding claim, wherein the compliant material member has a thickness which varies across at least one dimension of the compliant material member.

10. A device as claimed in any preceding claim, wherein a maximum size extension of each of the plurality of electroactive polymer micro-particles is between 0.1 and 3 micrometers.

11. A device as claimed in any preceding claim, wherein the plurality of electroactive polymer particles and the compliant material member form a composite structure having a total volume, and wherein the plurality of electroactive polymer particles constitute a fraction of this total volume of between 1% and 70%.

12. A device as claimed in any preceding claim, wherein the compliant material member comprises a first major surface and a second major surface opposing the first major surface, and wherein the plurality of electroactive polymer micro-particles consists of a single row of spatially separated electroactive polymer micro-particles, each extending between the first major surface and the second major surface.

13. A method of producing a device as claimed in any of the preceding claims, the method comprising forming a compliant material member (20) by means of a compound extrusion process comprising:
forming a dosed flexible material by continuously or periodically dosing a flexible material with micro-particles (28) of electroactive polymer material; and
extruding the dosed flexible material so as to provide the compliant material member (20) having a plurality of embedded electroactive polymer micro-particles (28).

14. A method as claimed in claim 13, further comprising controlling the rate at which the flexible material is dosed with electroactive polymer particles so as to vary it over time.

## Patentansprüche

1. Ein Gerät mit einer verformbaren Oberfläche, wobei das Gerät Folgendes umfasst:
- ein nachgiebiges Materialelement (20), das ein Volumen aufweist;
- mehrere elektroaktive Polymer-Mikropartikel (28), die eine maximale äußere Ausdehnung von weniger als 100 µm aufweisen und im Volumen verteilt sind, wobei die elektroaktiven Polymer-Mikropartikel sich als Reaktion auf das Anlegen eines elektrischen Reizes verformen;
- mindestens eine Elektrodenanordnung (32, 34), die an mehrere Reihen von elektroaktiven Polymer-Mikropartikeln (28) einen elektrischen Reiz anlegt; und
- eine Steuerung, die die mindestens eine Elektrodenanordnung steuert, um elektrische Reize an die Mikropartikel anzulegen, wobei die Reize in unterschiedlichen Bereichen des nachgiebigen Materialelements verschiedene Betätigungsreaktionen induzieren, um dadurch eine Verformung des nachgiebigen Materialelements zu bewirken, die auf der verformbaren Oberfläche ein ungleichmäßiges Verformungsprofil verursacht, und das sich dadurch auszeichnet, dass die Reize die verschiedenen Betätigungsreaktionen in unterschiedlichen Bereichen des nachgiebigen Materialelements induzieren. Dies beruht auf mindestens einem der folgenden Aspekte:
i. unterschiedliche elektrische Reize, die auf verschiedene Teilmengen von Mikropartikeln (28) innerhalb des nachgiebigen Materialelements (20) mithilfe räumlich verteilter Anordnungen (40, 42) von einzeln ansprechbaren und steuerbaren Elektroden aufgebracht werden;
ii. unterschiedliche Mikropartikel-Dichten (28) in verschiedenen Bereichen des nachgiebigen Materialelements (20) ; und
iii. geordnete Untergruppen von Mikropartikeln (28) mit unterschiedlichen Formen und/oder Größen im nachgiebigen Materialelement (20).

2. Ein Gerät gemäß Anspruch 1, wobei die elektroaktiven Polymer-Mikropartikel mehrere Untergruppen von Mikropartikeln umfassen, und
wobei die elektrischen Reize in den verschiedenen Untergruppen unterschiedliche Betätigungsreaktionen induzieren.

3. Ein Gerät gemäß einem der vorhergehenden Ansprüche, wobei die elektroaktiven Polymer-Mikropartikel auf mindestens zwei Dimensionen des Volumens des nachgiebigen Materialelements verteilt sind.

4. Ein verformbares Gerät gemäß einem der vorhergehenden Ansprüche,
wobei die elektroaktiven Polymer-Mikropartikel im nachgiebigen Materialelement eine Dichte aufweisen, die über das gesamte Volumen des nachgiebigen Materialelements konstant oder homogen verläuft; oder
wobei die elektroaktiven Polymer-Mikropartikel eine Dichte aufweisen, die über das gesamte Volumen des nachgiebigen Materialelements variiert.

5. Ein Gerät gemäß einem der vorhergehenden Ansprüche, wobei das nachgiebige Materialelement eine Hauptoberfläche aufweist, und wobei das Gerät zudem eine mit der Hauptoberfläche verbundene unnachgiebige Trägerschicht aufweist, um ein Verbiegen des nachgiebigen Materialelements in Reaktion auf einen elektrischen Reiz zu bewirken, und
wobei die unnachgiebige Trägerschicht optional mehrere isolierte Abschnitte umfasst, die auf der Hauptoberfläche positioniert sind, um ein ungleichmäßiges Verbiegen des nachgiebigen Materialelements in Reaktion auf den elektrischen Reiz zu bewirken.

6. Ein Gerät gemäß einem der vorhergehenden Ansprüche, wobei das nachgiebige Materialelement eine Hauptoberfläche aufweist, und wobei das Gerät zudem eine flexible Trägerschicht aufweist, die mit der Hauptoberfläche verbunden ist und eine Elastizität aufweist, die über die Hauptoberfläche variiert.

7. Ein Gerät gemäß einem der vorhergehenden Ansprüche, das mehrere voneinander unabhängig betreibbare Elektrodenanordnungen umfasst, um einen elektrischen Reiz an eine räumlich getrennte Teilmenge der elektroaktiven Polymer-Mikropartikel anzulegen.

8. Ein Gerät gemäß einem der vorhergehenden Ansprüche, wobei die elektroaktiven Mikropartikel im Volumen eine erste Teilmenge von Mikropartikeln mit einer ersten Form, Größe und/oder Ausrichtung und mindestens eine zweite Teilmenge von Mikropartikeln im Volumen mit einer zweiten Form, Größe und/oder Ausrichtung umfasst, die sich von der entsprechenden ersten Form, Größe und/oder Ausrichtung unterscheidet.

9. Ein Gerät gemäß einem der vorhergehenden Ansprüche, wobei das nachgiebige Materialelement eine Dicke aufweist, die über mindestens eine Dimension des nachgiebigen Materialelements variiert.

10. Ein Gerät gemäß einem der vorhergehenden Ansprüche, wobei die maximale Größenausdehnung der einzelnen elektroaktiven Polymer-Mikropartikel zwischen 0,1 und 3 Mikrometer beträgt.

11. Ein Gerät gemäß einem der vorhergehenden Ansprüche, wobei die elektroaktiven Polymerpartikel und das nachgiebige Materialelement eine Verbundstruktur mit einem Gesamtvolumen bilden, und wobei die elektroaktiven Polymerpartikel an diesem Gesamtvolumen einen Anteil von zwischen 1 % und 70 % ausmachen.

12. Ein Gerät gemäß einem der vorhergehenden Ansprüche, wobei das nachgiebige Materialelement eine erste Hauptoberfläche und eine zweite der ersten Hauptoberfläche gegenüberliegende Hauptoberfläche aufweist, und wobei die elektroaktiven Polymer-Mikropartikel aus einer einzelnen Reihe von räumlich getrennten elektroaktiven Polymer-Mikropartikeln besteht, die sich jeweils zwischen der ersten Hauptoberfläche und der zweiten Hauptoberfläche erstrecken.

13. Eine Methode zum Herstellen eines Geräts gemäß einem der vorherigen Ansprüche, wobei die Methode das Formen eines nachgiebigen Materialelements (20) mithilfe eines Verbundextrusionsverfahrens sowie folgende Schritte umfasst:
Formen eines dosierten flexiblen Materials durch kontinuierliches oder regelmäßiges Dosieren eines flexiblen Materials mit Mikropartikeln (28) aus elektroaktivem Polymermaterial; und
Extrudieren des dosierten flexiblen Materials, um das nachgiebige Materialelement (20) mit mehreren eingebetteten elektroaktiven Polymer-Mikropartikeln (28) bereitzustellen.

14. Eine Methode gemäß Anspruch 13, die zudem das Steuern der Rate, mit der das flexible Material mit elektroaktiven Polymerpartikeln dosiert wird, umfasst, sodass diese im Lauf der Zeit variiert.

## Revendications

1. Dispositif ayant une surface déformable, le dispositif comprenant :
- un élément de matériau souple (20), ayant un volume ;
- une pluralité de microparticules de matériau polymère électro-actif (28) ayant une extension externe maximale de moins de 100pm, et étant dispersées dans le volume, les microparticules en matériau polymère électro-actif étant conçues pour se déformer en réponse à l'application d'un stimulus électrique ;
- un ou plusieurs agencements d'électrodes (32, 34), pouvant fonctionner pour appliquer un stimulus électrique à un ensemble pluriel de microparticules en matériau polymère électro-actif (28), et
- un contrôleur configuré pour contrôler un ou plusieurs agencements d'électrodes pour appliquer des stimuli électriques à la pluralité de microparticules, les stimuli étant configurés pour induire des réponses d'activation différentes dans différentes régions de l'élément de matériau souple pour ainsi effectuer un changement de forme de l'élément de matériau souple configuré pour entraîner un profil de déformation non uniforme à travers la surface déformable, **caractérisé en ce que** les stimuli sont configurés pour induire des réponses d'activation différentes dans des régions différentes de l'élément de matériau souple basé sur un ou plusieurs des :
i. stimuli électriques différents appliqués à des sous-ensembles de microparticules différents (28) à l'intérieur de l'élément de matériau souple (20) par l'intermédiaire de réseaux spatialement distribués (40, 42) d'électrodes individuellement adressables et individuellement contrôlables ;
ii. densités différentes de microparticules (28) dans différentes régions de l'élément de matériau souple (20) ; et
iii. sous-groupes ordonnés de microparticules (28) de différentes formes et/ou tailles dans l'élément de matériau souple (20).

2. Dispositif selon la revendication 1, dans lequel la pluralité des microparticules en matériau polymère électro-actif comprend une pluralité de sous-ensembles de microparticules, et dans lequel les stimuli électriques sont configurés pour induire des réponses d'activation dans lesdits différents sous-ensembles.

3. Dispositif selon l'une quelconque des revendications précédentes, dans lequel la pluralité des microparticules en matériau polymère électro-actif est dispersée dans au moins deux dimensions à l'intérieur du volume de l'élément de matériau souple.

4. Dispositif de changement de forme selon l'une quelconque des revendications précédentes, dans lequel la pluralité des microparticules en matériau polymère électro-actif a une densité à l'intérieur de l'élément de matériau souple qui est constante ou homogène à travers tout le volume de l'élément de matériau souple ; ou
la pluralité des microparticules en matériau polymère électro-actif a une densité qui varie à travers tout le volume de l'élément de matériau souple.

5. Dispositif selon l'une quelconque des revendications précédentes, dans lequel l'élément de matériau souple comprend une surface principale, et le dispositif comprend en outre une couche support rigide couplée à la surface principale, pour effectuer un pliage de l'élément de matériau souple en réponse à un stimulus électrique, et éventuellement dans lequel ladite couche support rigide comprend une pluralité de sections isolées positionnées le long de ladite surface principale, pour induire un pliage non uniforme de l'élément de matériau souple en réponse au stimulus électrique.

6. Dispositif selon l'une quelconque des revendications précédentes, dans lequel l'élément de matériau souple comprend une surface principale, le dispositif comprenant en outre une couche support souple couplée à la surface principale et ayant une élasticité qui varie à travers la surface principale.

7. Dispositif selon l'une quelconque des revendications précédentes, comprenant une pluralité d'agencements d'électrodes, chacune d'elle fonctionnant de façon indépendante pour appliquer un stimulus électrique à un sous-ensemble spatialement distinct de microparticules en matériau polymère électro-actif.

8. Dispositif selon l'une quelconque des revendications précédentes, dans lequel la pluralité des microparticules en matériau polymère électro-actif comprend un premier sous-ensemble de microparticules ayant une première forme, taille et/ou orientation dans le volume, et au moins un second sous-ensemble de microparticules ayant une seconde forme, taille et/ou orientation dans le volume, qui est différent de la première forme, taille et/ou orientation correspondantes.

9. Dispositif selon l'une quelconque des revendications précédentes, dans lequel l'élément de matériau souple a une épaisseur qui varie à travers au moins une dimension de l'élément de matériau souple.

10. Dispositif selon l'une quelconque des revendications précédentes, dans lequel une extension de taille maximale de chacune de la pluralité des microparticules en matériau polymère électro-actif est entre 0,1 et 3 micromètres.

11. Dispositif selon l'une quelconque des revendications précédentes, dans lequel la pluralité des particules en matériau polymère électro-actif et l'élément de matériau souple forment une structure composite ayant un volume total, et dans lequel la pluralité des particules en matériau polymère électro-actif constitue une fraction de ce volume total entre 1% et 70%.

12. Dispositif selon l'une quelconque des revendications précédentes, dans lequel l'élément de matériau souple comprend une première surface principale et une seconde surface principale face à la première surface principale, et dans lequel la pluralité des microparticules en matériau polymère électro-actif consiste en une seule rangée de microparticules en matériau polymère électro-actif spatialement séparées, chacune s'étendant entre la première surface principale et la seconde surface principale.

13. Procédé de production d'un dispositif selon l'une quelconque des revendications précédentes, le procédé comprenant la formation d'un élément de matériau souple (20) par l'intermédiaire d'un processus d'extrusion composé comprenant :
la formation d'un matériau souple dosé en dosant de façon continue ou périodique un matériau souple avec des microparticules (28) en matériau polymère électro-actif ; et
l'extrusion du matériau souple dosé pour fournir l'élément de matériau souple (20) ayant une pluralité de microparticules en matériau polymère électro-actif incorporées (28).

14. Procédé selon la revendication 13, comprenant en outre le contrôle du taux auquel le matériau souple est dosé avec des particules en matériau polymère électro-actif afin de le faire varier au fil du temps.
